# EUROPÄISCHE PATENTSCHRIFT

(11) **EP 1 631 138 B1**
(45) Veröffentlichungstag und Bekanntmachung des Hinweises auf die Patenterteilung: **16.02.2011**
(21) Anmeldenummer: 05016520.8
(22) Anmeldetag: 29.07.2005
(51) Int. Cl.: H05K 13/00

(54) **Stützeinheit**
Support unit
Unité de support

(30) Priorität: 02.08.2004 DE 102004037501
(43) Veröffentlichungstag der Anmeldung: 01.03.2006
(60) Teilanmeldung: 10182416.7
(73) Patentinhaber: Fromm, Bernd, 72768 Reutlingen (DE)
(72) Erfinder: Fromm, Bernd, 72768 Reutlingen (DE)
(74) Vertreter: Hoeger, Stellrecht & Partner Patentanwälte

(56) Entgegenhaltungen:
- WO-A-00/16600
- US-A- 5 984 293
- US-B1- 6 711 797
- US-B1- 6 726 195

## Beschreibung

Die Erfindung betrifft eine Stützeinheit für die Abstützung einer Baugruppe auf einer höhenvariierenden Oberflächenkontur, insbesondere für die Abstützung von mit Bauteilen bestückten Leiterplatten, umfassend ein Basisgehäuse, in welchem mehrere Stützelemente in Richtung ihrer Längsrichtung zwischen einer eingefahrenen Stellung und einer ausgefahrenen Stellung bewegbar sind, Verschiebeeinheiten, mit denen die Stützelemente in Richtung der ausgefahrenen Stellung beaufschlagbar sind, und Fixiereinheiten, mit welchen die Stützelementen in ihren jeweiligen Stellungen gegenüber dem Basisgehäuse fixierbar sind. Entsprechende Stützeinheiten sind aus WO 00/16600 (ASCOM) und US 6,726,195 (Allen) bekannt.

Bei derartigen bekannten Stützelementen besteht das Problem, daß eine sichere Festlegung der Stützelemente in ihrer an der höhenvariierenden Oberflächenkontur der Baugruppe anliegenden Stellung schwierig ist.

Der Erfindung liegt daher die Aufgabe zugrunde, eine Stützeinheit der gattungsgemäßen Art derart zu verbessern, daß eine vorteilhafte Fixierung der Stützelemente möglich ist.

Diese Aufgabe wird bei einer Stützeinheit der eingangs beschriebenen Art gemäß Anspruch 1 gelöst.

Die Erfindung sieht vor, daß die Klemmhülsen aus einem elastischen Material hergestellt sind.

Besonders günstig lassen sich die Stützelemente dann festlegen, wenn die Klemmhülsen aus einem eine hohe Haftreibung an den Stützelementen aufweisenden Material ausgebildet sind.

Zweckmäßigerweise ist vorgesehen, daß die Klemmhülsen aus Gummi ausgebildet sind, da durch derartige aus Gummi ausgebildete Klemmhülsen eine hohe Reibung an den Stützelementen realisierbar ist.

Hinsichtlich der Kosten ist es besonders günstig, wenn die Klemmhülsen als Gummischlauchstücke ausgebildet sind, so daß diese in einfacher Weise von einem Gummischlauch durch Abbrennen von Segmenten herstellbar sind.

Die Erfindung sieht vor, daß die Betätigungseinrichtung mittels eines unter Druck setzbaren Mediums eine Kraftwirkung auf die Klemmkörper ausübt.

Des weiteren weist die Betätigungseinrichtung mindestens ein durch das Medium expandierbares Element auf, welches auf mindestens einen der Klemmkörper einwirkt.

Besonders zweckmäßig ist dabei eine Lösung, bei welcher die Betätigungseinrichtung als expandierbares Element einen expandierbaren Schlauchkörper aufweist.

Der Schlauchkörper kann dabei beliebig verlaufen.

Eine konstruktiv besonders zweckmäßige Lösung sieht dabei vor, daß der Schlauchkörper quer zu den Längsachsen der Stützelemente aufweist und dabei insbesondere seitlich an den Klemmkörpern vorbeiläuft.

Besonders zweckmäßig ist beim Vorsehen eines Schlauchkörpers, wenn mit diesem mehrere Klemmkörper beaufschlagbar sind.

Der Schlauchkörper könnte dabei mäanderförmig an den Klemmkörpern vorbeigeführt sein.

Zweckmäßigerweise ist vorgesehen, daß der Schlauchkörper längs einer Reihe von Stützelementen verläuft und deren Klemmkörper durch den Schlauchkörper beaufschlagbar sind.

Um bei einem expandierbaren Element sicherzustellen, daß eine möglichst große Kraft auf den Klemmkörper ausgeübt wird, ist zweckmäßigerweise vorgesehen, daß das expandierbare Element auf seiner auf den Klemmkörper wirkenden Seite mit einer Wandversteifung versehen ist.

Eine derartige Wandversteifung schafft die Möglichkeit, großflächig von dem expandieren Element die Expansionsbewegung aufzunehmen und auf den Klemmkörper überzuleiten.

Daher ist vorzugsweise vorgesehen, daß die Wandversteifung eine Expansion eines sich über den Klemmkörper hinaus erstreckenden Abschnitts des expandierbaren Elements auf den Klemmkörper überträgt.

Die Wandversteifung könnte in unterschiedlichster Art und Weise ausgeführt sein.

Beispielsweise könnte die Wandversteifung in eine Wand des expandierbaren Elements integriert sein. Besonders günstig ist es jedoch, wenn die Wandversteifung als ein vom expandierbaren Element getrenntes Element ausgebildet ist.

Die Wandversteifung könnte dabei halbschalenähnlich das expandierbare Element umschließen.

Eine besonders einfache Realisierungsform sieht vor, daß die Wandversteifung als Versteifungsstreifen ausgebildet ist.

Ein derartiger Versteifungsstreifen könnte beispielsweise ein Materialstreifen aus Kunststoff oder aus einem Metall sein.

Besonders zweckmäßig ist es dabei, wenn der Versteifungsstreifen aus einem teilflexiblen Material ist, so daß dieser sich in Grenzen an die Form des expandierbaren Elements anpassen kann.

Beispielsweise ist in diesem Fall der Versteifungsstreifen als schmaler Stahlstreifen aus Federstahl oder aus einem teilflexiblen Kunststoff ausgebildet.

Eine besonders zweckmäßige Lösung sieht vor, daß der Versteifungsstreifen längs der vom expandierbaren Element beaufschlagbaren Klemmkörper einer der Reihen von Stützelementen verläuft.

Hinsichtlich der Ausbildung des Basisgehäuses wurden bislang keine näheren Angaben gemacht. So sieht ein vorteilhaftes Ausführungsbeispiel vor, daß das Basisgehäuse zur Aufnahme der Klemmkörper und des expandierbaren Elements zwei Gehäuseteile aufweist.

Damit lassen sich die Klemmkörper und das expandierende Element in einfacher Weise innerhalb des Basisgehäuses montieren.

Besonders günstig ist es, wenn eine Trennebene der Gehäuseteile durch die Betätigungseinrichtung verläuft, so daß diese in einfacher Weise montiert werden kann.

Ferner ist es zur Fixierung des expandierbaren Elements günstig, wenn das expandierbare Element durch die Gehäuseteile endseitig klemmbar ist und somit in einfacher Weise beim Zusammenbau der Gehäuseteile innerhalb des Basisgehäuses fixiert werden kann.

Hinsichtlich der Verschiebeeinheiten wurden bislang keine näheren Angaben gemacht. So sieht eine vorteilhafte Lösung vor, daß die Verschiebeeinheiten einen Federkraftspeicher aufweisen.

Eine andere vorteilhafte Lösung sieht vor, daß die Verschiebeeinheiten mit Druckluftzufuhr arbeiten.

In diesem Fall ist es besonders günstig, die Druckluft so den Verschiebeeinheiten zuzuführen und aus diesen abzuleiten, daß dadurch eine luftpolsterunterstützte Führung der Stützelemente entsteht.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: eine perspektivische Ansicht eines ersten Ausführungsbeispiels eines erfindungsgemäßen Stützelements;
- Fig. 2: einen Schnitt längs Linie 2-2 in Fig. 1 bei nicht expandiertem Schlauchkörper;
- Fig. 3: einen teilweise dargestellten Schnitt längs Linie 3-3 in Fig. 2;
- Fig. 4: eine Darstellung ähnlich Fig. 2 bei expandiertem Schlauchkörper;
- Fig. 5: einen Schnitt längs Linie 3-3 in Fig. 2 in einem dem in Fig. 3 dargestellten Bereich gegenüberliegenden Bereich;
- Fig. 6: einen Schnitt ähnlich Fig. 2 durch ein zweites Ausführungsbeispiel einer erfindungsgemäßen Stützeinheit;
- Fig. 7: einen Schnitt ähnlich Fig. 4 durch das zweite Ausführungsbeispiel der erfindungsgemäßen Stützeinheit;
- Fig. 8: einen Schnitt durch eine Druckerzeugungsvorrichtung bei einem dritten Ausführungsbeispiel;
- Fig. 9: einen Schnitt durch eine Druckerzeugungsvorrichtung eines vierten Ausführungsbeispiels.

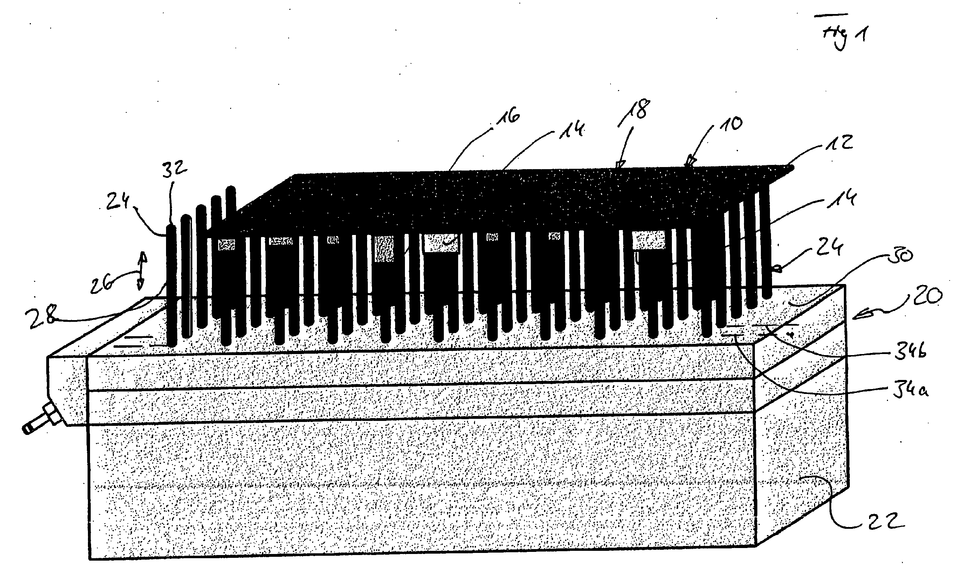

Ein Ausführungsbeispiel einer erfindungsgemäßen Stützeinheit, dargestellt in Fig. 1, dient zur Abstützung einer Baugruppe 10, welche beispielsweise eine Platine 12 umfaßt, auf welcher Bauteile 14 angeordnet sind, die insgesamt relativ zur Platine 12 eine höhenvariierende Oberflächenkontur 16 ergeben.

Um die Baugruppe 10 auf dieser höhenvariierenden Oberflächenkontur 16 abstützen zu können, beispielsweise beim Auftragen von Lot oder anderen Materialien auf einer den Bauteilen gegenüberliegende Seite 18 der Platine 12, ist eine als Ganzes mit 20 bezeichnete Stützeinheit vorgesehen, welche ein Basisgehäuse 22 umfaßt, in welchem eine Vielzahl von Stützelementen 24 in einer Verschieberichtung 26 beweglich gelagert sind, wobei die Stützelemente 24 sich mit parallel zueinander verlaufenden Schäften 28 und im Abstand voneinander über eine Oberseite 30 des Basisgehäuses 22 hinauserstrecken, und zwar bis zu einem Stützkopf 32, der allerdings in unterschiedlichem Abstand von der Oberseite 30 angeordnet ist, je nach dem, ob der Stützkopf 32 eines der Bauteile 14 oder die Platine 12 direkt abstützt.

Wie in Fig. 1 außerdem dargestellt, sind die Stützelemente 24 im Abstand voneinander in Reihen 34 angeordnet, die ebenfalls im Abstand voneinander parallel zueinander verlaufen, so daß in einem definierten Flächenmuster Stützelemente 24 zur Abstützung der Baugruppe 10 zur Verfügung stehen.

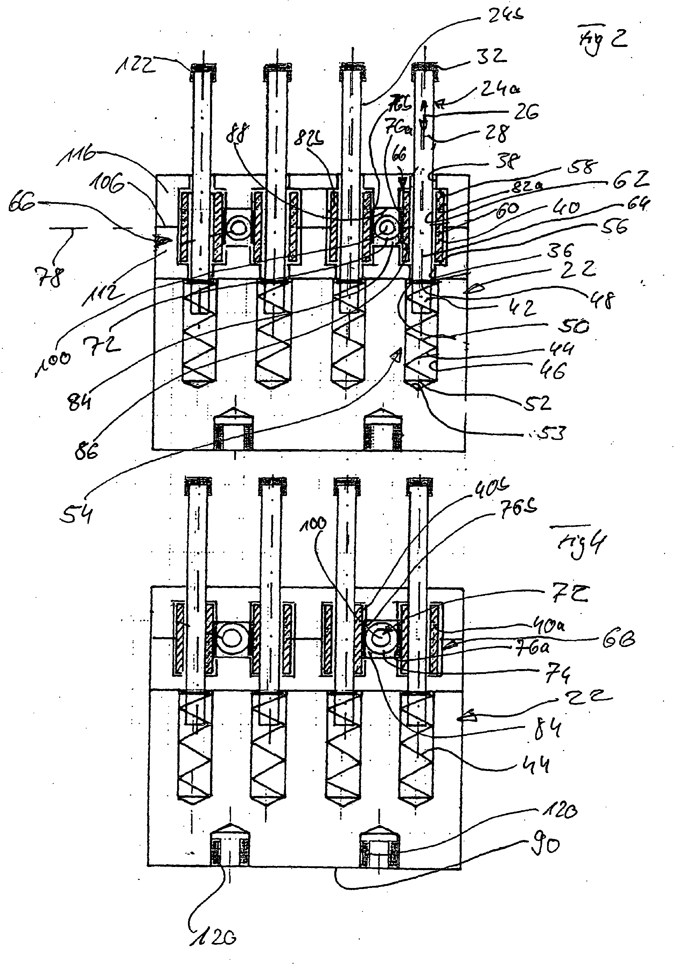

Die Stützelemente 24 sind, wie in Fig. 2 dargestellt, mit ihrem jeweiligen Schaft 28 in dem Basisgehäuse 22 in der Verschieberichtung 26 beweglich geführt, wobei eine Führung des jeweiligen Schafts 28 durch Führungsflächen 36, 38 des Basisgehäuses 22 erfolgt, die vorzugsweise beiderseits eines als Ganzes mit 40 bezeichneten Klemmkörpers angeordnet sind.

Ferner ist jeder Schaft 28 in einem dem Stützkopf 32 abgewandten Endbereich 42 durch einen elastischen Kraftspeicher 44 beaufschlagbar, welcher in einer Ausnehmung 46 im Basisgehäuse 22 angeordnet ist und mit einem Ende 48 auf eine Schulter 50 des jeweiligen Stützelements 24, beispielsweise gebildet durch eine am Schaft 28 im Endbereich 42 gehaltene Scheibe, wirkt, während sich der Kraftspeicher 44 mit seinem anderen Ende 52 an einem Boden 53 der Ausnehmung 46 abstützt. Der in der Ausnehmung 46 angeordnete Kraftspeicher 54 und die Schulter 50 bilden somit insgesamt eine Verschiebeeinrichtung 54 für jedes Stützelement 24.

Vorzugsweise liegen dabei der Kraftspeicher 44 und die Ausnehmung 46 auf einer dem Stützkopf 32 abgewandten Seite des Klemmkörpers 40.

Der Klemmkörper 40 ist in der Verschieberichtung 26 unverschieblich in dem Basisgehäuse 22 gehalten, beispielsweise durch Anordnung desselben zwischen zwei vom Basisgehäuse 22 gebildeten Halteschultern 56, 58.

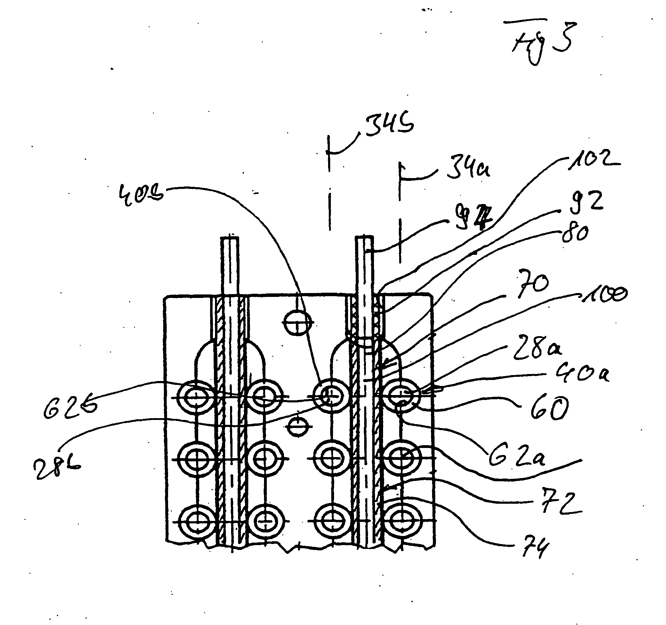

Vorzugsweise ist der Klemmkörper 40, wie in Fig. 3 dargestellt, als den jeweiligen Schaft 28 umfassende Hülse 60 aus einem elastischen Material, vorzugsweise aus einem Schlauchstück aus Gummi ausgebildet, so daß der Schaft 28 einen inneren Durchbruch 62 der Hülse 60 durchsetzt.

Dadurch, daß die Hülse 60 aus einem elastischen Material hergestellt ist, läßt sich der Schaft 28 in dem Durchbruch 62 der Hülse 60 kraftschlüssig dann festlegen, wenn auf die Hülse 60 eine in radialer Richtung zu einer Längsrichtung 64 des Schafts 28 gerichtete Kraft einwirkt, welche die Hülse 60 mit auf einer Seite des Schafts 28 anlegt und damit eine kraftschlüssige Verbindung zwischen dem Schaft 28 und der Hülse 60 schafft.

Zur Betätigung jeder Fixiereinheit 66 wie in Fig. 2, 3 und 4 dargestellt, eine Betätigungseinrichtung 70 vorgesehen, welche einen expandierbaren Schlauchkörper 72 umfaßt, dessen Mantel 74 bei einer Expansion desselben auf den Klemmkörper 40 wirkt.

Um die vom expandieren Schlauchkörper 72 erzeugbare Kraft auf die Hülse 60 optimal ausnützen zu können, ist der expandierbare Schlauchkörper 72 noch mit einer Wandversteifung 76 versehen, die zwischen dem Mantel 74 und der Hülse 60 liegt und sich längs des Schlauchkörpers 72 erstreckt.

Wie in den Fig. 2 bis 4 erkennbar, dient die Betätigungseinrichtung 70 zum Betätigen der Klemmkörper 40 zweier nebeneinander verlaufender Reihen 34a und 34b von Stützelementen 24, wobei sich der expandierbare Schlauchkörper 72 zwischen den beiden Reihen 34a und 34b quer zu der Längsrichtung 64 der Schäfte 28 der jeweiligen Stützelemente 24 erstreckt, vorzugsweise in einer senkrecht zu diesen liegenden Ebene 78 liegt.

Ferner liegt der Schlauchkörper zwischen den Klemmkörpern 40a, 40b der Stützelemente 24 der beiden Reihen, so daß eine Expansion des Mantels 77 des Schlauchkörpers 72 auf die auf gegenüberliegenden Seiten des expandierbaren Schlauchkörpers 72 liegenden Wandversteifungen 76a, 76b wirkt und über diese die auf gegenüberliegenden Seiten des expandierbaren Schlauchkörpers 72 angeordneten Klemmkörper 40a, 40b beaufschlagt.

Vorzugsweise liegen dabei die Klemmkörper 40a, 40b bezogen auf eine Längsrichtung 80 des expandierbaren Schlauchkörpers 72 auf gegenüberliegenden Seiten, so daß der Mantel 74 des expandierbaren Schlauchkörpers 72 im expandierten Zustand, wie in Fig. 4 dargestellt, zwischen den einander gegenüberliegenden Wandversteifungen 76a, 76b eingeklemmt ist und dadurch auf diese drückt, die ihrerseits wiederum mit ihren dem expandierbaren Schlauchkörper 72 abgewandten Seiten auf die auf gegenüberliegenden Seiten des Schlauchkörpers 72 angeordneten Klemmkörper 40a, 40b wirken und die Klemmkörper 40a, 40b gleichzeitig beaufschlagen.

Vorzugsweise liegen der expandierbare Schlauchkörper 72 und die Wandversteifungen 76a und 76b schwimmend zwischen den Klemmkörpern 40a, 40b der beiden Reihen 34a, 34b von Stützelementen 24a, 24b, so daß sich der expandierbare Schlauchkörper 72 selbst zwischen den Klemmkörpern 40a, 40b, zentriert und mit im wesentlichen derselben Kraft jeden der Klemmkörper 40a, 40b in einer radial zur Längsrichtung 64 des jeweiligen Schafts 28 verlaufenden Richtung beaufschlagt, und damit den jeweiligen Schaft 28a, 28b in dem Durchbruch 62a, 62b des jeweiligen Klemmkörpers kraftschlüssig festlegt, so daß der Schaft 28 aufgrund der Festlegung des Klemmkörpers 40 zwischen den Halteschultern 56 und 58 im Basisgehäuse 22 ebenfalls nicht mehr in der Verschieberichtung 26 relativ zum Basisgehäuse 22 bewegbar ist.

Zur Aufnahme des expandierbaren Schlauchkörpers 72 ist vorzugsweise zwischen im Basisgehäuse 22 vorgesehenen und die Halteschultern 56 und 58 aufweisenden Aufnahmen 82a, 82b für die einander gegenüberliegenden Klemmkörper 40a, 40b ein symmetrisch zur Ebene 78 verlaufender Durchbruch 84 vorgesehen, welcher jeweils im Bereich der Aufnahme 82a, 82b diese durchdringt und sich zwischen den beiden Reihen 34a, 34b von Stützelementen 24 über die gesamte Längsausdehnung der Reihen 34a, 34b von Stützelementen 24a, 24b erstreckt.

Ferner ist der Durchbruch 84 ebenfalls noch so ausgebildet, daß die Wandversteifungen 76a, 76b durch eine sich ungefähr zur Ebene 78 parallel erstreckende Bodenfläche 86 sowie eine sich ungefähr parallel zur Ebene 78 erstreckende Deckelfläche 88 des Durchbruchs 84 geführt sind.

Vorzugsweise ist der Durchbruch 84 symmetrisch zur Ebene 78 ausgebildet, so daß auch die Bodenfläche 86 und die Deckelfläche 88 symmetrisch zur Ebene 78 liegen.

Ferner verläuft auch der expandierbare Schlauchkörper 72 vorzugsweise ungefähr symmetrisch zur Ebene 78 in gleicher Weise wie die Wandversteifungen 76a und 76b.

Insbesondere ist der Abstand der Bodenfläche 86 von der Wandfläche 88 beim jeweiligen Durchbruch so gewählt, daß, wie in Fig. 4 dargestellt, bei expandiertem Schlauchkörper 72 der Mantel 74 im wesentlichen an diesen anliegt, so daß der expandierbare Schlauchkörper 72 im expandierten Zustand auch an der Bodenfläche 86 und der Deckelfläche 88 abgestützt ist, die einander gegenüberliegen, und außerdem ist der expandierte Schlauchkörper 72 an den quer zu diesen verlaufenden Wandversteifungen 76a und 76b in einer ungefähr parallel zur Bodenfläche 86 oder Deckelfläche 88 verlaufenden Richtung auf gegenüberliegenden Seiten ebenfalls abgestützt.

Im expandierten Zustand des Schlauchkörpers 72 werden daher die Wandversteifungen 76a und 76b durch den Mantel 74 des expandierbaren Schlauchkörpers 72 beaufschlagt und auseinanderbewegt, um auf die Klemmkörper 40a, 40b zum Festlegen der Schäfte 28 der Stützelemente 24 einzuwirken.

Die erfindungsgemäße Stützeinheit 20 funktioniert nun so, daß die von den Kraftspeichern 44 ausgeübten Kräfte ausreichend stark sind, um im unbelasteten Zustand der Stützelemente 24 diese maximal aus dem Basisgehäuse 22 auszufahren und somit die Stützköpfe 32 im maximalen möglichen Abstand von der Oberseite 30 des Basisgehäuses 22 zu positionieren.

Bei Auflegen der Baugruppe auf die durch die Stützkörper 32 der Stützelemente 24 zur Verfügung gestellten Abstützstellen werden die Stützelemente 24 in der Verschieberichtung 26 zumindest dann, wenn diese auf einem Bauteil 14 aufsitzen, in Richtung des Basisgehäuses 22 gegen die Kraft der einzelnen Kraftspeicher 44 verschoben, und zwar so, daß in der Regel jedes der Stützelemente 24 die zu unterstützende Baugruppe 10, beispielsweise entweder an der Platine 10 oder an einem Bauteil 14, abstützt, wodurch die Stützelemente 24 bei Abstützen der Baugruppe 10 in einer unterschiedlich weit aus dem Basisgehäuse 22 ausgefahrenen Stellung stehen.

Die Kraftspeicher 44 sind vorzugsweise so ausgebildet, daß die Summe aller die Baugruppe 10 auf der Oberfächenkontur 16 mit ihren Stützköpfen 32 beaufschlagenden Stützelemente 24 in der Lage ist die, Baugruppe im unbeaufschlagten Zustand zu tragen.

Dabei sind üblicherweise diejenigen Stützelemente 24, die die Oberflächenkontur 16 in ihrer tiefsten Stelle, also beispielsweise die Platine 12 direkt, beaufschlagen, maximal aus dem Basisgehäuse 22 ausgefahren, das heißt, sie steht in ihrer in Fig. 2 oder 4 dargestellten maximal ausgefahrenen Stellung, während diejenigen Stützelemente 24, die mit ihren Stützköpfen 32 eines der Bauteile 14 auf der Platine 12 beaufschlagend abstützen in einer teilweise in das Basisgehäuse 22 eingefahrenen Stellung stehen.

Die Stützelemente 24 lassen sich erfindungsgemäß in allen beliebigen Stellungen, das heißt sowohl in der maximal ausgefahrenen Stellung als auch einer maximal eingefahrenen Stellung oder einer Zwischenstellung durch expandieren des Schlauchkörpers 72 kraftschlüssig in den Durchbrüchen 62 der Klemmelemente 40 und somit auch kraftschlüssig relativ zum Basisgehäuse 22 festlegen, so daß die Baugruppe 10 auf ihrer Seite 18 mit zusätzlichen Kräften beaufschlagt werden kann, die über die Summe aller Stützelemente 24 und deren kraftschlüssige Festlegung relativ zum Basisgehäuse 22 vom Basisgehäuse 22 aufgenommen und vom Basisgehäuse 22 über eine Fußfläche 90 weitergegeben werden kann.

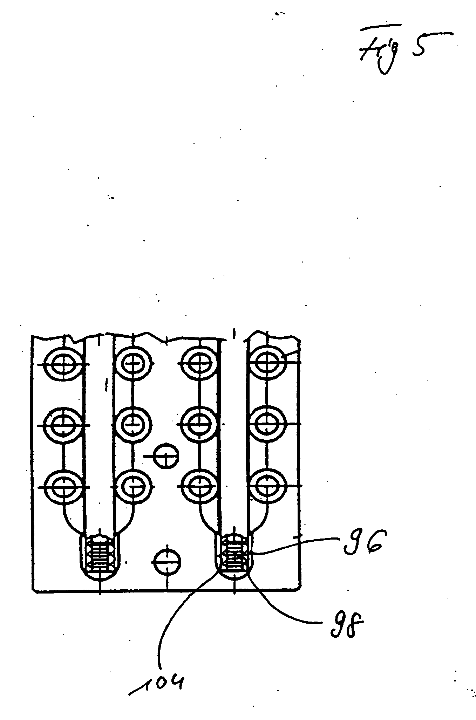

Wie in Fig. 3 und 5 dargestellt, ist der expandierbare Schlauchkörper 72 im Bereich eines Endes 92 mit einem Druckanschluß 94 versehen und im Bereich eines gegenüberliegenden Endes 96 beispielsweise über einen Blindstopfen 98 verschlossen. Durch Zuführen von einem unter Druck stehenden Medium über den Druckanschluß 94 ist der Schlauchkörper 72 in einfacher Weise durch das zuführbare Medium expandierbar, wobei dieses Medium ein flüssiges oder gasförmiges Medium sein kann.

Im einfachsten Fall läßt sich hierzu Luft einsetzen.

Besonders günstig ist der expandierbare Schlauchkörper 72 dann in dem Basisgehäuse 22 fixierbar und festlegbar, wenn die Enden 92 und 96 desselben in Bohrungen 102 und 104 des Basisgehäuses 22 liegen und durch den eingesetzten Druckanschluß 94 bzw. den eingesetzten Blindstopfen 98 aufgrund der durch diese bedingten Aufweitung der Enden 92 bzw. 96 kraftschlüssig fixiert sind, so daß insgesamt eine Festlegung des expandierbaren Schlauchkörpers 72 in dem Durchbruch 84 gegeben ist.

Um einen einfachen Zusammenbau des Basisgehäuses 22, insbesondere im Bereich der Aufnahmen 82 für die Klemmkörper 40 und die Durchbrüche 84 für die expandierbaren Schlauchkörper 72 sowie die Wandversteifungen 76 zu erreichen, ist vorzugsweise das Basisgehäuse 22 mit einer mit der Ebene 78 zusammenfallenden Trennebene 106 versehen, so daß der die Aufnahmen 82 und die Durchbrüche 84 umfassende Bereich des Basisgehäuses 22 in zwei Teile 112 und 116 zerlegbar ist, um die Klemmelemente 40 sowie die Betätigungseinrichtung 70 mit dem Schlauchkörper 72 und den Wandversteifungen 76 einfach montieren zu können, da die Trennebene 106 vorzugsweise sowohl die Aufnahmen 82 als auch die Durchbrüche 84 ungefähr hälftig durchtrennt.

Zur Montage der erfindungsgemäßen Stützeinheit 20 in einer Vorrichtung sind beispielsweise im Bereich nahe der Fußfläche 90 Halteelemente 120 vorgesehen, die entweder als Gewindelöcher ausgebildet sein können oder als Haltemagnete, um die Stützeinheiten magnetisch auf einem Untergrund zu fixieren.

Darüber hinaus ist vorzugsweise der Stützkopf 32 jedes Stützelements 24 mit einer Kappe 122 aus elektrisch leitfähigem Kunststoff versehen, um die Baugruppe 10, insbesondere Bauteile 14 derselben beim Abstützen nicht zu beschädigen.

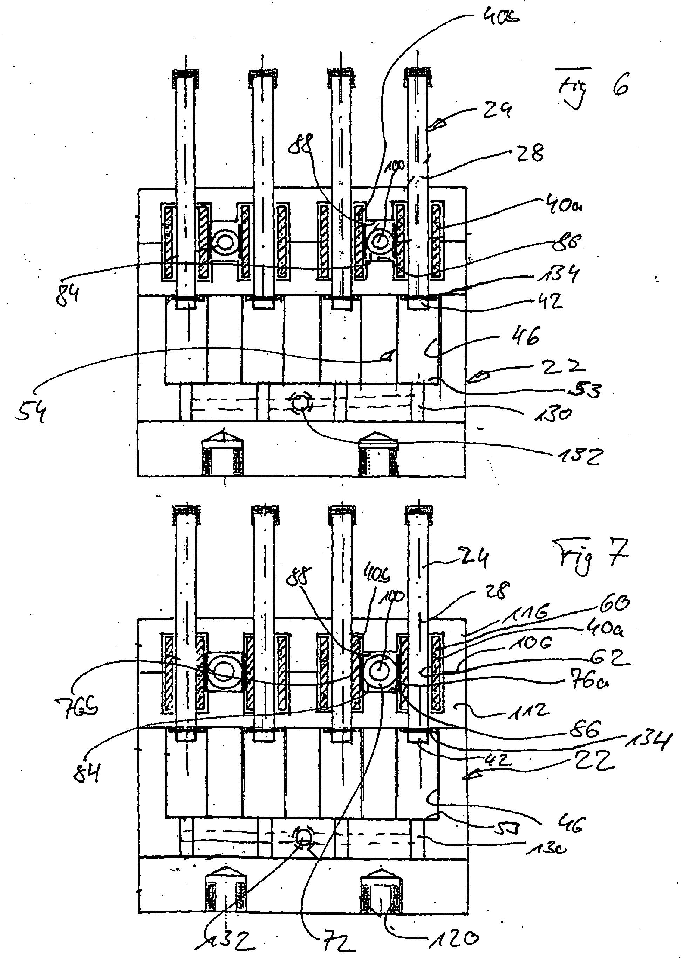

Bei einem zweiten Ausführungsbeispiel einer erfindungsgemäßen Stützeinheit 20, dargestellt in Fig. 6 und Fig. 7 sind diejenigen Elemente, die mit denen des ersten Ausführungsbeispiels identisch sind, mit denselben Bezugszeichen versehen, so daß hinsichtlich der Beschreibung derselben vollinhaltlich auf die Ausführungen zum ersten Ausführungsbeispiel Bezug genommen werden kann.

Im Gegensatz zum ersten Ausführungsbeispiel sind in den Ausnehmungen 46 keine Kraftspeicher 44 angeordnet, sondern die Ausnehmungen 46 sind über Druckkanäle 130 mit einem Druckanschluß 132 verbunden, über welchen ein unter Druck stehendes Medium den Ausnehmungen 46 im Bereich ihres Bodens 53 zugeführt werden kann.

Sind die Schäfte 28 in deren Endbereichen 42 mit einem Flanschkörper 134 versehen, welcher zwar nicht zwingend dichtend an Wandflächen der Ausnehmungen 46 anliegt, jedoch im wesentlichen bis zu Wandflächen derselben reicht. Somit läßt sich durch einen ständigen Strom eines über die Druckkanäle 130 den Ausnehmungen 46 im Bereich ihres Bodens 54 zugeführten Mediums erreichen, daß dieses Medium auf die Flanschkörper 134 und die Schäfte 28 wirkt und die Schäfte 28 der Stützelemente 24 in Richtung ihrer maximal ausgefahrenen Stellung verschiebt.

Damit lassen sich die Stützelemente 24 in gleicher Weise wie beim ersten Ausführungsbeispiel alle so positionieren, daß jedes der an der Baugruppe 10 anlegbaren Stützelemente 24 mit seinem Stützkopf 32 an der Baugruppe 10 anliegt und diese im ansonsten unbelasteten Zustand unterstützt, so daß sich insgesamt die Baugruppe durch die Gesamtheit aller im Bereich der Baugruppe 10 angeordneten Stützelemente 24 abstützen läßt.

Dabei läßt sich die Kraft, mit welcher die Stützelemente 24 auf die Baugruppe 10 wirken, durch Variation des Drucks des über den Druckanschluß 132 und die Druckkanäle 130 den Ausnehmungen 46 zugeführten Mediums einstellen, so daß je nach Gewicht der Baugruppe 10 eine Anpassung der von den Stützelementen 24 ausgeübten Kräfte möglich ist.

Ist dann die unbelastete Baugruppe 10 durch sämtliche zu deren Abstützung heranziehbaren Stützelemente 24 abgestützt, so kann dann die Fixierung der Stützelemente 24 durch die Klemmkörper 40 erfolgen.

Das an den Flanschkörpern 134 vorbeiströmende Medium umströmt dabei jeweils den Schaft 28 und durchströmt die Führungsflächen 36, die Klemmkörper 40 und die Führungsflächen 38, so daß das Medium im Bereich der Oberseite 30 des Basisgehäuses 22 wieder aus diesem austritt.

Durch eine derartige Führung des Mediums werden nicht nur die Stützelemente 24 mit einer Kraft in Richtung der maximal ausgefahrenen Stellung beaufschlagt, sondern gleichzeitig wird die Reibung des jeweiligen Schafts 28 im Bereich der Führungsflächen 36 und 38 sowie der Klemmkörper 40 reduziert, so daß der Schaft 28 in der Verschieberichtung 26 leicht bewegbar ist und somit bereits durch geringe von dem zugeführten Medium ausgeübte Kräfte in seine maximal ausgefahrene Stellung bewegt werden kann.

Somit lassen sich insbesondere auch geringe, auf die Stützelemente 24 wirkende Kräfte einstellen, um mit wenig Kraft empfindliche Bauteile 14 der Baugruppe 10 beaufschlagen zu können.

Im Rahmen des ersten und zweiten Ausführungsbeispiels wurde die Erzeugung des Drucks in dem expandierbaren Schlauchkörper 72 nicht näher erläutert.

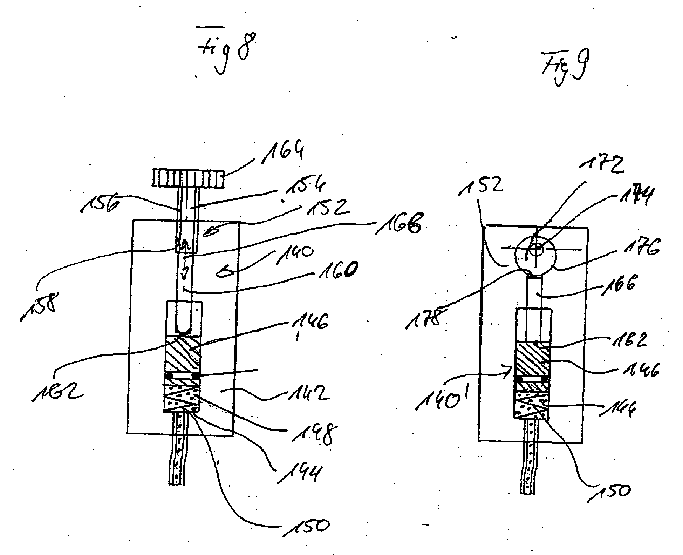

Beispielsweise läßt sich eine Druckerzeugung 140 einsetzen, wie sie in Fig. 8 dargestellt ist.

Diese Druckerzeugung 140 umfaßt einen Zylinderkörper 142, in welchem eine Zylinderkammer 144 angeordnet ist, innerhalb von welcher ein Kolben 146 bewegbar ist.

Mit dem Kolben läßt sich das Volumen der Zylinderkammer 144 variabel vergrößern und somit Medium 148 aufnehmen oder in den Innenraum 100 des expandierbaren Schlauchkörpers 72 einführen, um dessen Mantel 74 zu expandieren.

Vorzugsweise ist dabei der Kolben 146 durch einen federelastischen Kraftspeicher 150 in Richtung einer einem maximalen Zylinderkammervolumen entsprechenden Stellung beaufschlagt, so daß der Kolben 146 selbsttätig die Tendenz hat, stets in die Stellung überzugehen, in welcher die Zylinderkammer 144 das größte Volumen hat.

Der Kolben ist ferner durch eine Beaufschlagungsvorrichtung 152 beaufschlagbar, welche eine Gewindespindel 154 umfaßt, welche mit ihrem Gewindeabschnitt 156 in ein Innengewinde 158 des Zylinderkörpers eingreift und mit einem Fortsatz 160 den Kolben 146 beaufschlagt, wobei der Fortsatz 160 mit einem vorderen Ende 162 an dem Kolben 146 anliegt, wobei der Kolben 146 seinerseits aufgrund des federelastischen Elements 150 an dem Ende 162 in Anlage gehalten wird.

Je nach Drehung der Gewindespindel 154, beispielsweise über ein Handbetätigungselement 164, läßt sich die Gewindespindel 156 und somit der Fortsatz 160 in einer Verschieberichtung 168 bewegen und somit kann der Kolben 146 entgegengesetzt zur Wirkung des federelastischen Elements 150 in Richtung einer Verkleinerung des Zylinderkammervolumens verschoben werden, so daß dadurch das Medium 148 in den Innenraum 100 des expandierbaren Schlauchkörpers 72 überführt wird, der dadurch expandiert und die Klemmkörper 40 beaufschlagt.

Andererseits läßt sich durch Verdrehen der Gewindespindel 156 das Ende 162 in Richtung der Kraftwirkung des federelastischen Elementes 150 bewegen, so daß der Kolben aufgrund der Wirkung des federelastischen Elements 150 sich in Richtung einer das Zylinderkammervolumen vergrößernden Stellung bewegt und Medium 148 aus dem Innenraum 100 des expandierbaren Schlauchkörpers 72 in die Zylinderkammer 44 überführt wird, so daß der expandierbare Schlauchkörper 72 sein Volumen verkleinert und nicht mehr die Klemmkörper 40 einwirkt.

Bei einem vierten Ausführungsbeispiel, dargestellt in Fig. 9, sind diejenigen Teile, die mit denen des dritten Ausführungsbeispiels identisch sind, mit denselben Bezugszeichen versehen.

Im Gegensatz zum dritten Ausführungsbeispiel umfaßt die Beaufschlagungsvorrichtung 152 einen Exzenterkörper 172, welcher um eine Drehachse 174 drehbar in dem Zylinderkörper 142 gelagert ist.

Der Exzenterkörper 172 wirkt seinerseits mit seiner Umfangsfläche 176 auf ein Ende 178 des Stößels 166, der seinerseits wiederum mit dem Ende 162 in bekannter Weise auf den Kolben 146 wirkt.

Durch Verdrehen des Exzenterkörpers 172 kann nun der Stößel 166 so verschoben werden, daß er den Kolben 146 in eine, das Zylinderkammervolumen verkleinernde Stellung bewegt oder in eine das Zylinderkammervolumen vergrößernde Stellung zuläßt, in welche der Kolben 146 aufgrund der Wirkung des federelastischen Elements 150 bewegbar ist.

Insoweit, als beim vierten Ausführungsbeispiel die gleichen Teile Verwendung finden, wie beim dritten Ausführungsbeispiel, sind dieselben Bezugszeichen verwendet und es wird hinsichtlich der Beschreibung dieser Teile vollinhaltlich auf die Ausführungen zum vierten Ausführungsbeispiel Bezug genommen.

Als Medium kann bei einer Druckerzeugungsvorrichtung gemäß dem dritten oder vierten Ausführungsbeispiel sowohl ein gasförmiges Medium als auch ein flüssiges Medium, das heißt beispielsweise Luft als gasförmiges Medium oder Öl als flüssiges Medium Verwendung finden.

## Patentansprüche

1. Stützeinheit für die Abstützung einer Baugruppe (10) auf einer höhenvariierenden Oberflächenkontur (16), insbesondere für die Abstützung von mit Bauteilen bestückten Leiterplatten, umfassend ein Basisgehäuse (22), in welchem mehrere Stützelemente (24) in Richtung ihrer Längsrichtung zwischen einer eingefahrenen Stellung und einer ausgefahrenen Stellung bewegbar geführt sind, Verschiebeeinheiten (54), mit denen die Stützelemente in Richtung der ausgefahrenen Stellung beaufschlagbar sind, und Fixiereinheiten (66), welche auf die Stützelemente (24) wirkende Klemmkörper (40) umfassen, mit welchen die Stützelemente (24) in ihren jeweiligen Stellungen gegenüber dem Basisgehäuse (22) fixierbar sind, und eine Betätigungseinrichtung (70) zum Beaufschlagen der Klemmkörper (40),
**dadurch gekennzeichnet, dass** die Betätigungseinrichtung (70) mindestens ein mittels eines unter Druck setzbaren Mediums expandierbares Element (72) aufweist, mit welchem auf mindestens einen der Klemmkörper (40) eine Kraftwirkung ausübbar ist.

2. Stützeinheit nach Anspruch 1, **dadurch gekennzeichnet, dass** die Betätigungseinrichtung als expandierbares Element einen expandierbaren Schlauchkörper (72) aufweist.

3. Stützeinheit nach Anspruch 2, **dadurch gekennzeichnet, dass** der Schlauchkörper (72) quer zu den Längsrichtungen (64) der Stützelemente (24) verläuft.

4. Stützeinheit nach Anspruch 2 oder 3, **dadurch gekennzeichnet, dass** mit dem Schlauchkörper (72) mehrere Klemmkörper (40) beaufschlagbar sind.

5. Stützeinheit nach Anspruch 4, **dadurch gekennzeichnet, dass** der Schlauchkörper (72) längs einer Reihe (34) von Stützelementen (24) verläuft und deren Klemmkörper (40) durch den Schlauchkörper (72) beaufschlagbar sind.

6. Stützeinheit nach einem der voranstehenden Ansprüche, **dadurch gekennzeichnet, dass** das expandierbare Element (72) auf seiner auf den Klemmkörper (40) wirkenden Seite mit einer Wandversteifung (76) versehen ist.

7. Stützeinheit nach Anspruch 6, **dadurch gekennzeichnet, dass** die Wandversteifung (76) eine Expansion eines sich über den Klemmkörper (40) hinauserstreckenden Abschnitts des expandierbaren Elements (72) auf den Klemmkörper überträgt.

8. Stützeinheit nach Anspruch 6 oder 7, **dadurch gekennzeichnet, dass** die Wandversteifung (76) als vom expandierbaren Element getrenntes Element ausgebildet ist.

9. Stützeinheit nach Anspruch 8, **dadurch gekennzeichnet, dass** die Wandversteifung als Versteifungsstreifen (76) ausgebildet ist.

10. Stützeinheit nach Anspruch 8 oder 9 **dadurch gekennzeichnet, dass** der Versteifungsstreifen längs der vom expandierbaren Element (72) beaufschlagbaren Klemmkörper (40) einer der Reihen (34) von Stützelementen (24) verläuft.

11. Stützeinheit nach einem der voranstehenden Ansprüche, **dadurch gekennzeichnet, dass** die Klemmkörper (40) als Klemmhülsen (60) ausgebildet sind.

12. Stützeinheit nach Anspruch 11, **dadurch gekennzeichnet, dass** die Klemmhülsen (60) aus einem elastischen Material hergestellt sind.

13. Stützeinheit nach Anspruch 12, **dadurch gekennzeichnet, dass** die Klemmhülsen (60) aus einem eine hohe Haftreibung an den Stützelementen (24) aufweisenden Material ausgebildet sind.

14. Stützeinheit nach Anspruch 13, **dadurch gekennzeichnet, dass** die Klemmhülsen (60) aus Gummi ausgebildet sind.

15. Stützeinheit nach Anspruch 14, **dadurch gekennzeichnet, dass** die Klemmhülsen (60) als Gummischlauchstücke ausgebildet sind.

16. Stützeinheit nach einem der voranstehenden Ansprüche, **dadurch gekennzeichnet, dass** das Basisgehäuse (22) zur Aufnahme der Klemmkörper (40) und der Betätigungseinrichtung (70) zwei Gehäuseteile (112, 116) aufweist.

17. Stützeinheit nach Anspruch 16, **dadurch gekennzeichnet, dass** eine Trennebene (106) der Gehäuseteile (112, 116) durch die Betätigungseinrichtung (70) verläuft.

18. Stützeinheit nach Anspruch 16 oder 17, **dadurch gekennzeichnet, dass** das expandierbare Element (72) durch die Gehäuseteile (112, 116) endseitig klemmbar ist.

19. Stützeinheit nach einem der voranstehenden Ansprüche, **dadurch gekennzeichnet, dass** die Verschiebeeinheiten (54) elastische Kraftspeicher (44) aufweisen, welche die Stützelemente (24) in Richtung der ausgefahrenen Stellung beaufschlagen.

20. Stützeinheit nach einem der Ansprüche 1 bis 18, **dadurch gekennzeichnet, dass** die Verschiebeeinheiten (54) druckluftbetätigt die Stützelemente (24) in Richtung ihrer ausgefahrenen Stellung beaufschlagen.

21. Stützeinheit nach Anspruch 20, **dadurch gekennzeichnet, dass** die Stützelemente (24) im Basisgehäuse (22) luftpolsterunterstützt geführt sind.

## Claims

1. Support unit for the support of a subassembly (10) on a surface contour (16) variable in height, in particular for the support of printed circuit boards equipped with components, comprising a base housing (22), several supporting elements (24) being guided in said housing for movement in the direction of their longitudinal direction between a retracted position and an extended position, displacing units (54) for acting on the supporting elements in the direction of the extended position and fixing units (66) comprising clamping members (40) acting on the supporting elements (24), the supporting elements (24) being adapted to be fixed by the clamping members in their respective positions in relation to the base housing (22), and an actuating device (70) for acting on the clamping members (40),
**characterized in that** the actuating device (70) has at least one element (72) expandable by means of a medium subjectable to pressure, an effective force being exertable on at least one of the clamping members (40) with said element.

2. Support unit as defined in claim 1, **characterized in that** the actuating device has an expandable hose member (72) as expandable element.

3. Support unit as defined in claim 2, **characterized in that** the hose member (72) extends transversely to the longitudinal directions (64) of the supporting elements (24).

4. Support unit as defined in claim 2 or 3, **characterized in that** several clamping members (40) are adapted to be acted upon with the hose member (72).

5. Support unit as defined in claim 4, **characterized in that** the hose member (72) extends along a row (34) of supporting elements (24) and their clamping members (40) are adapted to be acted upon by the hose member (72).

6. Support unit as defined in any one of the preceding claims, **characterized in that** the expandable element (72) is provided with a wall reinforcement (76) on its side acting on the clamping member (40).

7. Support unit as defined in claim 6, **characterized in that** the wall reinforcement (76) transfers an expansion of a section of the expandable element (72) extending beyond the clamping member (40) to the clamping member.

8. Support unit as defined in claim 6 or 7, **characterized in that** the wall reinforcement (76) is designed as an element separate from the expandable element.

9. Support unit as defined in claim 8, **characterized in that** the wall reinforcement is designed as a reinforcement strip (76).

10. Support unit as defined in claim 8 or 9, **characterized in that** the reinforcement strip extends along the clamping members (40) of one of the rows (34) of supporting elements (24), said clamping members being acted upon by the expandable element (72).

11. Support unit as defined in any one of the preceding claims, **characterized in that** the clamping members (40) are designed as clamping sleeves (60).

12. Support unit as defined in claim 11, **characterized in that** the clamping sleeves (60) are produced from an elastic material.

13. Support unit as defined in claim 12, **characterized in that** the clamping sleeves (60) are designed from a material having a high frictional adhesion to the supporting elements (24).

14. Support unit as defined in claim 13, **characterized in that** the clamping sleeves (60) are formed from rubber.

15. Support unit as defined in claim 14, **characterized in that** the clamping sleeves (60) are formed from pieces of rubber hose.

16. Support unit as defined in any one of the preceding claims, **characterized in that** the base housing (22) has two housing sections (112, 116) for accommodating the clamping members (40) and the actuating device (70).

17. Support unit as defined in claim 16, **characterized in that** a plane of separation (106) of the housing sections (112, 116) extends through the actuating device (70).

18. Support unit as defined in claim 16 or 17, **characterized in that** the expandable element (72) is adapted to be clamped by the housing sections (112, 116) at its ends.

19. Support unit as defined in any one of the preceding claims, **characterized in that** the displacing units (54) have elastic force storing devices (44) acting on the supporting elements (24) in the direction of the extended position.

20. Support unit as defined in any one of claims 1 to 18, **characterized in that** the displacing units (54) act on the supporting elements (24) in the direction of their extended position acted upon by compressed air.

21. Support unit as defined in claim 20, **characterized in that** the supporting elements (24) are guided in the base housing (22) aided by a cushion of air.

## Revendications

1. Unité de support pour supporter un module (10) sur un contour de surface (16) réglable en hauteur, en particulier pour supporter des plaquettes de circuits imprimés munies de composants, comportant un boîtier de base (22), dans lequel plusieurs éléments de support (24) sont logés de manière mobile dans le sens de leur direction longitudinale entre une position introduite et une position extraite, des unités de déplacement (54) par lesquelles les éléments de support peuvent être sollicités vers leur position extraite, et des unités d'immobilisation (66) qui comportent des corps de serrage (40), qui agissent sur les éléments de support (24) et par lesquels les éléments de support (24) peuvent être immobilisés dans leurs positions respectives par rapport au boîtier de base (22), et un dispositif d'actionnement (70) pour solliciter les corps de serrage(40), **caractérisée en ce que** le dispositif d'actionnement (70) comporte au moins un élément (72), qui est expansible au moyen d'un milieu mis sous pression et avec lequel une force peut être appliquée sur au moins un des corps de serrage (40).

2. Unité de support selon la revendication 1, **caractérisée en ce que** le dispositif d'actionnement comporte un corps tubulaire (72) expansible pour former l'élément expansible.

3. Unité de support selon la revendication 2, **caractérisée en ce que** le corps tubulaire (72) est orienté transversalement aux directions longitudinales (64) des éléments de support (24).

4. Unité de support selon la revendication 2 ou 3, **caractérisée en ce que** plusieurs corps de serrage (40) peuvent être sollicités par le corps tubulaire (72).

5. Unité de support selon la revendication 4, **caractérisée en ce que** le corps tubulaire (72) s'étend le long d'une rangée (34) d'éléments de support (24) et les corps de serrage (40) de ces derniers peuvent être sollicités par le corps tubulaire (72).

6. Unité de support selon l'une quelconque des revendications précédentes, **caractérisée en ce que** l'élément expansible (72) est muni d'un raidissement de paroi (76) sur le côté agissant sur le corps de serrage (40).

7. Unité de support selon la revendication 6, **caractérisée en ce que** le raidissement de paroi (76) transmet sur le corps de serrage une expansion d'un tronçon de l'élément expansible (72), qui s'étend au-delà du corps de serrage (40).

8. Unité de support selon la revendication 6 ou 7, **caractérisée en ce que** le raidissement de paroi (76) est réalisé sous la forme d'un élément séparé de l'élément expansible.

9. Unité de support selon la revendication 8, **caractérisée en ce que** le raidissement de paroi est réalisé sous la forme d'une bande de raidissement (76).

10. Unité de support selon la revendication 8 ou 9, **caractérisée en ce que** la bande de raidissement s'étend le long du corps de serrage (40), propre à être sollicité par l'élément expansible (72), de l'une des rangées (34) d'éléments de support (24).

11. Unité de support selon l'une quelconque des revendications précédentes, **caractérisée en ce que** les corps de serrage (40) sont réalisés sous forme de douilles de serrage (60).

12. Unité de support selon la revendication 11, **caractérisée en ce que** les douilles de serrage (60) sont réalisées dans un matériau élastique.

13. Unité de support selon la revendication 12, **caractérisée en ce que** les douilles de serrage (60) sont réalisées dans un matériau possédant un frottement statique élevé au niveau des éléments de support (24).

14. Unité de support selon la revendication 13, **caractérisée en ce que** les douilles de serrage (60) sont réalisées en caoutchouc.

15. Unité de support selon la revendication 14, **caractérisée en ce que** les douilles de serrage (60) sont réalisées sous forme de bouts de tuyau flexible en caoutchouc.

16. Unité de support selon l'une quelconque des revendications précédentes, **caractérisée en ce que** le boîtier de base (22) comporte deux parties (112, 116) pour loger les corps de serrage (40) et le dispositif d'actionnement (70).

17. Unité de support selon la revendication 16, **caractérisée en ce qu'**un plan de séparation (106) des parties (112, 116) du boîtier passe par le dispositif d'actionnement (70).

18. Unité de support selon la revendication 16 ou 17, **caractérisée en ce que** l'élément expansible (72) peut être bloqué du côté de son extrémité par les parties (112, 116) du boîtier.

19. Unité de support selon l'une quelconque des revendications précédentes, **caractérisée en ce que** les unités de déplacement (54) comportent des accumulateurs d'énergie (44) élastiques, qui sollicitent les éléments de support (24) vers leur position extraite.

20. Unité de support selon l'une quelconque des revendications 1 à 18, **caractérisée en ce que** les unités de déplacement (54) actionnées par air comprimé sollicitent les éléments de support (24) vers leur position extraite.

21. Unité de support selon la revendication 20, **caractérisée en ce que** les éléments de support (24) sont logés dans le boîtier de base (22) en étant supportés par des coussins d'air.
